# EUROPEAN PATENT SPECIFICATION

(11) **EP 2 076 922 B1**
(45) Date of publication and mention of the grant of the patent: **05.09.2012**
(21) Application number: 08765221.0
(22) Date of filing: 30.05.2008
(51) Int. Cl.: H01L 23/31, H01L 23/485, H01L 23/532, H01L 23/525

(54) **SEMICONDUCTOR DEVICE HAVING LOW DIELECTRIC INSULATING FILM AND MANUFACTURING METHOD OF THE SAME**
HALBLEITERELEMENT MIT EINEM FILM MIT NIEDRIGER DIELEKTRISCHER ISOLATION UND VERFAHREN ZU SEINER HERSTELLUNG
DISPOSITIF SEMI-CONDUCTEUR AYANT UN FILM ISOLANT À FAIBLE CONSTANTE DIÉLECTRIQUE ET SON PROCÉDÉ DE FABRICATION

(30) Priority: 21.09.2007 JP 2007244977; 28.02.2008 JP 2008047090
(43) Date of publication of application: 08.07.2009
(73) Proprietor: Teramikros, Inc., Tokyo 198-8555 (JP)
(72) Inventor: MIZUSAWA, Aido, Hamura-shi, Tokyo 205-8555 (JP); OKADA, Osamu, Hamura-shi, Tokyo 205-8555 (JP); WAKABAYASHI, Takeshi, Hamura-shi, Tokyo 205-8555 (JP); MIHARA, Ichiro, Hamura-shi, Tokyo 205-8555 (JP)
(74) Representative: Grünecker, Kinkeldey, Stockmair & Schwanhäusser
(86) International application number: PCT/JP2008/060408
(87) International publication number: WO 2009/037902

(56) References cited:
- EP-A- 1 298 725
- EP-A- 1 737 037
- US-A1- 2002 024 145
- US-A1- 2002 100 984
- US-A1- 2005 170 641
- US-B1- 6 559 548

## Description

### Technical Field

The present invention relates to a semiconductor device and a method for manufacturing the same, and particularly a semiconductor device having wiring lines on a low dielectric film.

### Background Art

As semiconductor devices to be mounted on small-sized electronic devices represented by portable electronic devices and the like, there are known chip size packages (CSPs) each having dimensions substantially equal to that of a semiconductor substrate. Among the CSPs, a CSP in which packaging is completed in a wafer state and which is separated into individual semiconductor devices by dicing is also referred to as a wafer level package (WLP).

In the conventional semiconductor device as described above (refer to, for example, Jpn. Pat. Appln. KOKAI Publication No. 2004-349461), wiring lines are extended from connection pads on the upper surface of an insulating film which covers the connection pads formed on the semiconductor substrate, a number of columnar electrodes are respectively arranged on the upper surfaces of connection pad portions formed on ends of the extended wiring lines, and a sealing film is formed so as to cover the wiring lines between the columnar electrodes on the upper surface of the insulating film. The sealing film is formed so that the upper surface of the sealing film and the upper surfaces of the columnar electrodes are on one plane. Solder balls are respectively provided on the upper surfaces of the columnar electrodes.

Among such semiconductor devices as described above, there is a device in which an interlayer insulating film wiring line laminated structure portions each including a laminated structure of interlayer insulating films and the wiring lines is provided between the semiconductor substrate and the insulating film. In this device, when an interval between the wiring lines of the interlayer insulating film wiring line laminated structure portion decreases with miniaturization of the semiconductor devices, a capacity between the wiring lines increases, with the result that a delay of a signal which transmits through the wiring lines increases.

To improve this point, as a material of the interlayer insulating film, much attention is paid to a low dielectric material such as a low-k material having a dielectric constant lower than a dielectric constant of 4.2 to 4.0 of silicon oxide which is generally used as the material of the interlayer insulating film. Examples of the low-k material include SiOC obtained by doping silicon oxide (SiO₂) with carbon (C), and SiOCH further containing H. To further lower the dielectric constant, air-containing porous type low dielectric films are also being investigated.

In the above semiconductor device including the low dielectric film, especially the low dielectric film represented by the porous type low dielectric film having a hollow structure has a small mechanical strength and is easily influenced by moisture. As a result, there is a problem that the low dielectric film easily peels from an underlayer.

EP-A-1 298 725 relates to a semiconductor device of a multi-wiring structure, particularly, to the structure of an insulating film within the same wiring layer.

US 2002/024145 A1 discloses a semiconductor device using a fluorinated silicate glass film as an interlayer metal dielectric film.

EP-A-1 737 037 relates to a method for fabricating a circuitry component. The method comprises the steps of providing a semiconductor wafer, a first metal layer, and a first polymer layer.

US-B1-6 559 548 relates to a wiring structure of a semiconductor device comprising a first insulating layer, a wiring layer, a second insulating layer, a first via plug, an electrode pad and a second via plug.

US 2005/170641 A1 discloses a method for forming a buried wiring in a low-k dielectric film.

US 2002/100984 A1 relates to a semiconductor device having wirings formed in wiring grooves and a connection member formed integrally with the wirings in via holes for connecting the wirings and lower layer wirings thereof.

### Disclosure of Invention

An object of the present invention is to provide a semiconductor device capable of significantly avoiding a problem of peeling of a low dielectric film, and a method for manufacturing the same.

A semiconductor device according to one aspect of the present invention comprises a semiconductor substrate and a low dielectric film wiring line laminated structure portion which is provided on one surface of the semiconductor substrate. The low dielectric film wiring line laminated structure portion has a laminated structure including a plurality of low dielectric films and a plurality of wiring lines, each of the low dielectric films having a relative dielectric constant of 3.0 or lower and a glass transition temperature of 400°C or higher. An insulating film is formed at least on the low dielectric film wiring line laminated structure portion. On the insulating film, there are provided a connection pad portion for an electrode so as to be connected to a connection pad portion of an uppermost wiring line of the low dielectric film wiring line laminated structure portion, a bump electrode for external connection, provided on the connection pad portion for the electrode, and a sealing film made of an organic resin and provided at least on a part of the insulating film which surrounds the pump electrode for the external connection. Side surfaces of the low dielectric film wiring line laminated structure portion are covered with one of the insulating film and the sealing film.

A method for manufacturing a semiconductor device according to another aspect of the present invention comprises preparing a semiconductor wafer, on one surface of which a low dielectric film wiring line laminated structure portion is formed, the low dielectric film wiring line laminated structure portion including low dielectric films and wiring lines, the low dielectric films having a relative dielectric constant of 3.0 or lower and a glass transition temperature of 400°C or higher. In the next, parts of the low dielectric film wiring line laminated structure portion in regions above dicing streets and regions on opposite sides of the dicing streets are removed by applying laser beams, thereby forming a groove exposing side surfaces of the low dielectric film wiring line laminated structure portion. Thereafter, an organic resin film covering the side surfaces of the low dielectric film wiring line laminated structure portion is formed. Then, the organic resin film and the semiconductor wafer are cut along the dicing streets, thereby obtaining a plurality of semiconductor devices.

### Brief Description of Drawings

FIG. 1 is a sectional view of a semiconductor device as a first example
FIG. 2 is a sectional view of an assembly first prepared during manufacturing of the semiconductor device shown in FIG. 1;
FIG. 3 is a sectional view of an assembly in a step subsequent to FIG. 2;
FIG. 4 is a sectional view of an assembly in a step subsequent to FIG. 3;
FIG. 5 is a sectional view of an assembly in a step subsequent to FIG. 4;
FIG. 6 is a sectional view of an assembly in a step subsequent to FIG. 5;
FIG. 7 is a sectional view of an assembly in a step subsequent to FIG. 6;
FIG. 8 is a sectional view of an assembly in a step subsequent to FIG. 7;
FIG. 9 is a sectional view of an assembly in a step subsequent to FIG. 8;
FIG. 10 is a sectional view of an assembly in a step subsequent to FIG. 9;
FIG. 11 is a sectional view of an assembly in a step subsequent to FIG. 10;
FIG. 12 is a sectional view of an assembly in a step subsequent to FIG. 11;
FIG. 13 is a sectional view of an assembly in a step subsequent to FIG. 12;
FIG. 14 is a sectional view of a semiconductor device as a first embodiment of the present invention;
FIG. 15 is a sectional view of an assembly in a predetermined step during manufacturing of the semiconductor device shown in FIG. 14;
FIG. 16 is a sectional view of an assembly in a step subsequent to FIG. 15;
FIG. 17 is a sectional view of an assembly in a step subsequent to FIG. 16;
FIG. 18 is a sectional view of an assembly in a step subsequent to FIG. 17;
FIG. 19 is a sectional view of an assembly in a step subsequent to FIG. 18;
FIG. 20 is a sectional view of a semiconductor device as a second embodiment of the present invention;
FIG. 21 is a sectional view of a semiconductor device ;
FIG. 22 is a sectional view of a semiconductor device ; and
FIG. 23 is a sectional view of a semiconductor device .

### Best Mode for Carrying Out the Invention

### First Example

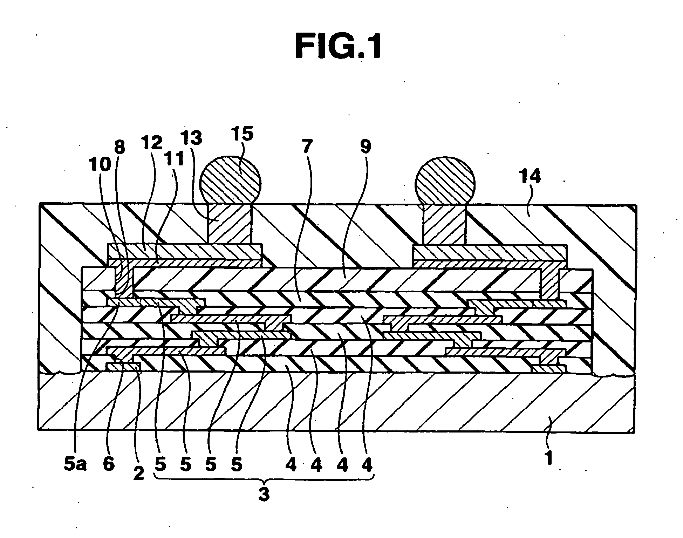

FIG. 1 shows a sectional view of a semiconductor device as a first example. This semiconductor device includes a silicon substrate (a semiconductor substrate) 1. On the upper surface of the silicon substrate 1, a number of active semiconductor elements, such as transistors, are provided (not shown). In a peripheral portion of the upper surface of the substrate 1, a number of connection pads 2 made of an aluminum-based metal or the like are electrically connected to the respective semiconductor elements, although the figure shows only two pads. The connection pads 2 are input and/or output terminals of each semiconductor element, and/or a power supply terminal.

On the upper surface of the silicon substrate 1, excluding peripheral portions outside the connection pads 2, a low dielectric film/wiring line/laminated structure portion 3 is provided. The laminated structure portion 3 has a structure in which there are alternately laminated a plurality of layers, for example, four layers of low dielectric films 4 and the same number of layers of wiring lines 5 made of copper or an aluminum-based metal or the like.

Examples of a material of the low dielectric films 4 include a polysiloxane-based material having an Si-O bond and an Si-H bond (HSQ:Hydrogen silsesquioxane having a relative dielectric constant of 3.0), a polysiloxane-based material having an Si-O bond and an Si-CH₃ bond (MSQ:Methyl silsesquioxane having a relative dielectric constant of 2.7-2.9), carbon-doped silicon oxide (SiOC having a relative dielectric constant of 2.7-2.9) and an organic polymer-based low-k material. The materials having a relative dielectric constant of 3.0 or lower and a glass transition temperature of 400°C or higher can be used.

Examples of the organic polymer-based low-k material include "SiLK (having a relative dielectric constant of 2.6)" produced by Dow Chemical Company and "FLARE (having a relative dielectric constant of 2.8)" produced by Honeywell Electronic Materials Company. The glass transition temperature of 400°C or higher is a condition for tolerance to a temperature in a manufacturing step or steps to be described later. A porous type of each of the above materials may also be used.

Besides the above, the material of the low dielectric films 4 may also be a material which has a relative dielectric constant higher than 3.0 in a normal condition, but can have a relative dielectric constant of 3.0 or lower and a glass transition temperature of 400°C or higher when it becomes porous. For example, fluorinated silicate glass (FSG having a relative dielectric constant of 3.5-3.7), boron-doped silicate glass (BSG having a relative dielectric constant of 3.5) or silicon oxide (having a relative dielectric constant of 4.0-4.2) may be used.

In the low dielectric film wiring line laminated structure portion 3, the wiring lines 5 between the low dielectric films 4 are electrically connected to each other through holes formed in the films 4. One end portion of the wiring line 5 of the lowermost layer is electrically connected to the connection pad 2 via an opening 6 formed in the low dielectric film 4 of the lowermost layer. Connection pad portions 5a of the wiring lines 5 of an uppermost layer are arranged on an upper surface peripheral portion of the low dielectric film 4 of the uppermost layer.

A passivation film 7 made of an inorganic material such as silicon oxide is provided on the upper surfaces of the uppermost wiring lines 5 and the low dielectric films 4 of the uppermost layer. Openings 8 are formed through the passivation film 7 in portions corresponding to the connection pad portions 5a of the wiring lines 5 of the uppermost layer. On the upper surface of the passivation film 7, there is provided a protective film (insulating film) 9 made of an organic material containing polyimide, epoxy, phenol, bismaleimide, acryl, synthetic rubber, polybenzoxide or the like as a main component. Openings 10 are formed through the protective film 9 in portions corresponding to the openings 8 of the passivation film 7.

On the upper surface of the protective film 9, metallic underlayers 11 made of copper or the like are provided. On the whole upper surface of each of the metallic underlayers 11, an upper layer wiring line 12 made of copper is provided. End portions of the upper layer wiring line 12 and the metallic underlayers 11, are connected to the connection pad portions 5a of the wiring lines 5 of the uppermost layer via the openings 8, 10 of the passivation film 7 and the protective film 9. On the upper surfaces of connection pad portions (connecting pad portions for electrodes) of the upper layer wiring lines 12, there are provided columnar electrodes (bump electrodes for external connection) 13 made of copper.

On the upper surfaces of the upper layer wiring liners 12 and the protective film 9, and the upper surface of the peripheral portion of the silicon substrate 1, there is provided a sealing film 14 made of an organic material such as an epoxy-based resin so that the upper surface of the sealing film and the upper surfaces of the columnar electrodes 13 are on one plane. In this state, the side surfaces of the low dielectric film wiring line laminated structure portion 3, the passivation film 7 and the protective film 9 form substantially one plane and are entirely covered with the sealing film 14. Solder balls 15 are provided on the upper surfaces of the columnar electrodes 13.

As described above, in this semiconductor device, a region on the silicon substrate 1 except the peripheral portion is provided with the low dielectric film wiring line laminated structure portion or structure portions 3 each including the laminated structure of the low dielectric films 4 and the wiring lines 5, and the side surfaces of the low dielectric film wiring line laminated structure portion 3, the passivation film 7 and the protective film 9 are covered with the sealing film 14. Therefore, the low dielectric film wiring line laminated structure portion 3 does not easily peel from the silicon substrate 1.

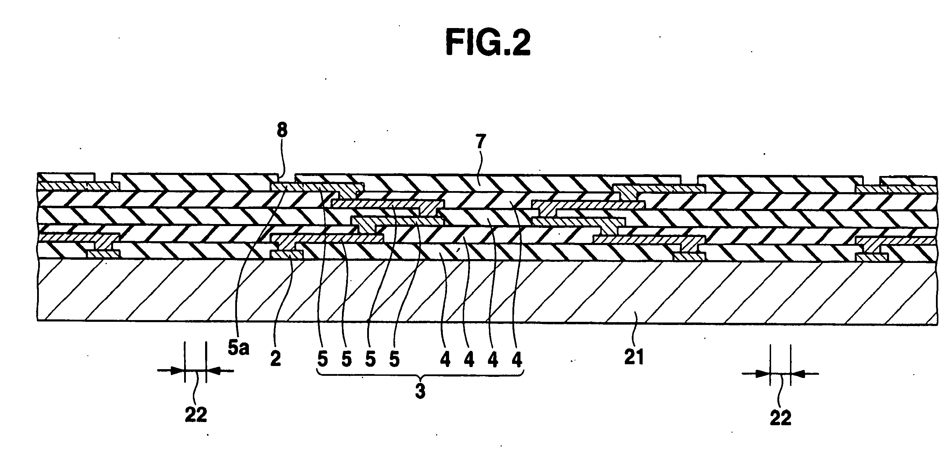

Next, one example of a method for manufacturing the semiconductor device mentioned above will be described. First, as shown in FIG. 2, an assembly is prepared, in which on a silicon substrate (hereinafter referred to as a semiconductor wafer 21) of a wafer state, there are arranged the connection pads 2 and the low dielectric film wiring line laminated structure portions 3 each including four layers of low dielectric films 4 and wiring lines 5. In the assembly, the passivation film 7 is provided on the laminated stricture portions 3, and the centers of the connection pad portions 5a of the wiring lines 5 of the uppermost layer are exposed via the openings 8 provided in the passivation film 7.

Examples of a low dielectric film material 4 may be those, including a porous type, as described above, which have a relative dielectric constant of 3.0 or lower and a glass transition temperature of 400°C or higher. It is to be noted that regions denoted with reference numeral 22 in FIG. 2 are regions corresponding to dicing streets.

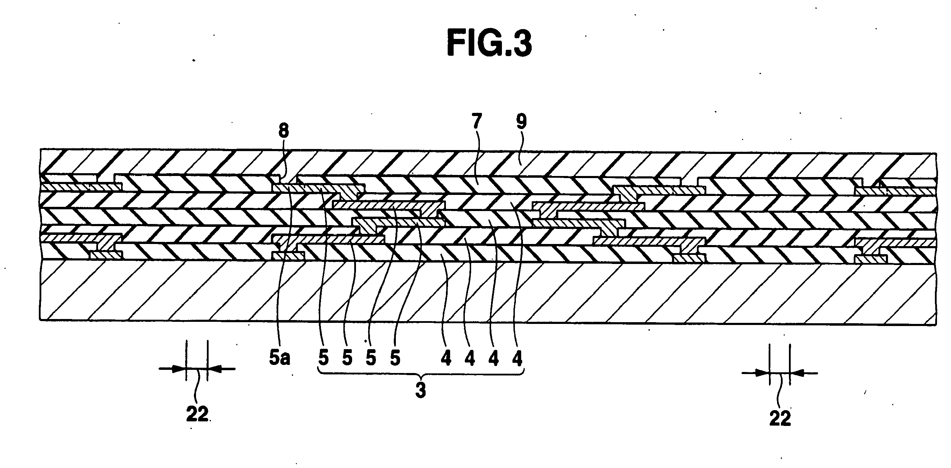

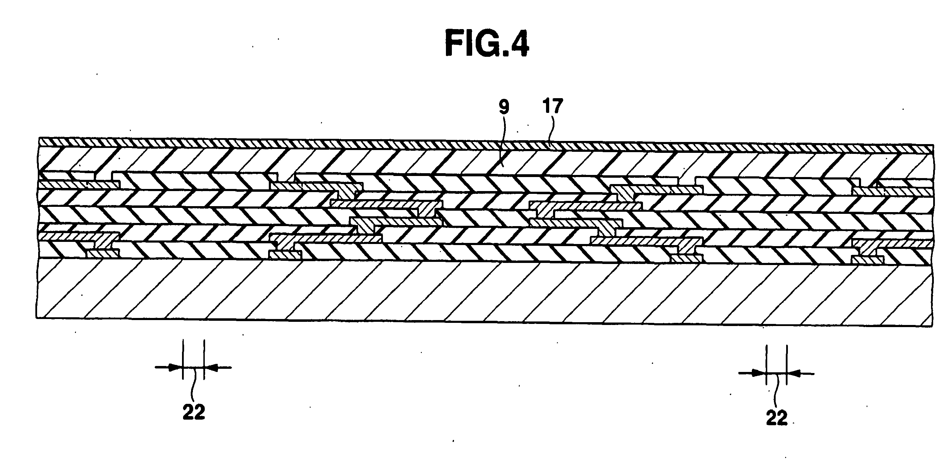

Next, as shown in FIG. 3, by a screen printing process, a spin coating process or the like, the protective film 9 made of an organic material such as a polyimide-based resin is formed on the upper surface of the passivation film 7 and the upper surfaces of the connection pad portions 5a of the wiring lines 5 of the uppermost layer exposed via the openings 8 of the passivation film 7. Then, as shown in FIG. 4, a water-soluble protective film 17, made of water-soluble polymers such as polyvinyl alcohol (PVA) or polyacrylamide (PAM), is formed on the upper surface of the protective film 9 by a screen printing process, a spin coating process or the like.

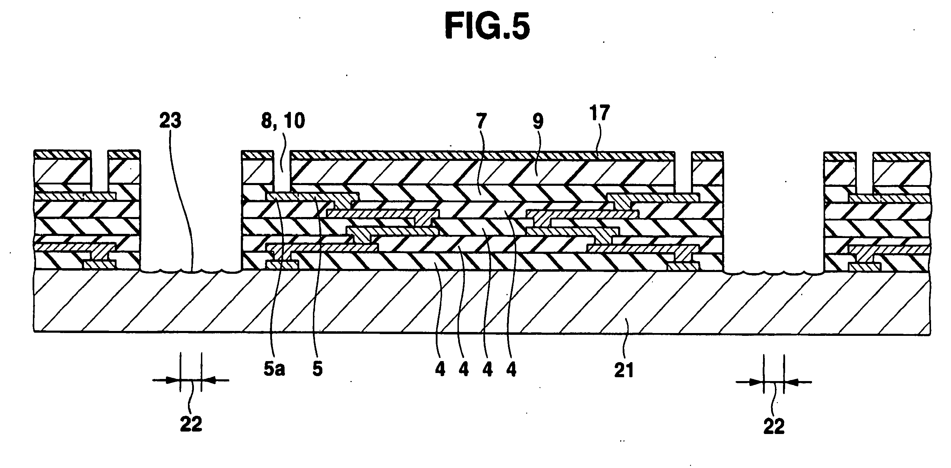

Next, as shown in FIG. 5, by laser processing which emits a laser beam, there are removed portions of the water soluble protective film 17, the protective film 9, the passivation film 7 and four layers of the low dielectric films 4 positioned in regions of the dicing streets 22 and regions on opposite sides of the streets to form latticed grooves 23. Further, the openings 8 and 10 are formed through the passivation film 7 and the water soluble protective film 17 in portions corresponding to the connection pad portions 5a of the wiring lines 5 of the uppermost layer.

In this process, when the laser beam is radiated on the low dielectric films 4, the low dielectric films 4 melt and scatter as low dielectric film pieces. The scattered low dielectric film pieces drop on and stick into the upper surface of the water soluble protective film 17, not the upper surface of the protective film 9. Then, when the water soluble protective film 17 is washed with water and removed, the low dielectric film pieces stuck into the upper surface of the water soluble protective film 17 are also removed simultaneously. If the scattered low dielectric film pieces are sucked by evacuation, the water soluble protective film 17 may be unnecessary.

The low dielectric films 4 are brittle.
Therefore, if the grooves 23 are cut in the films 4 by using a blade, the cut surface of the low dielectric films 4 will have many notches and cracks. In view of this, it is recommended that the low dielectric films 4 be cut by the laser beam to make grooves 23. If the grooves 23 are worked by the laser beam, the upper surface of the silicon substrate 1 melts, when irradiated with the laser beam, and molten silicon particles jump and then fall onto the silicon substrate 1. Inevitably, each groove 23 will have an uneven bottom surface as shown in FIG. 5.

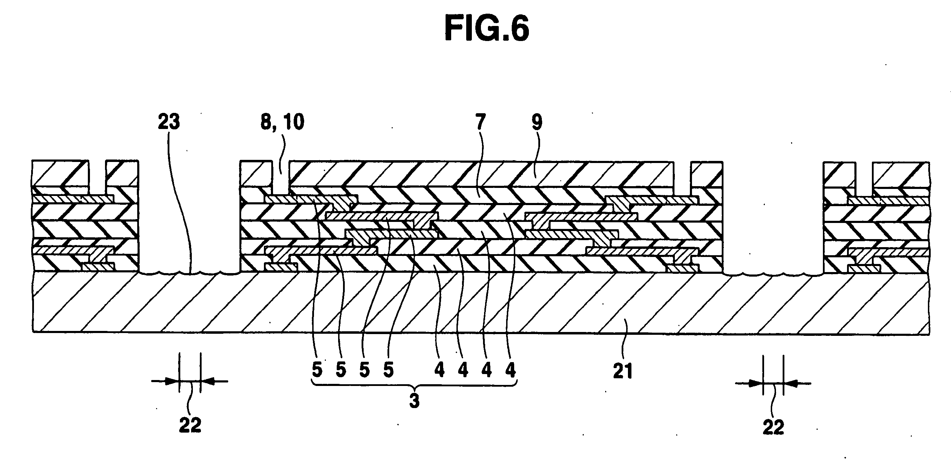

In this state, that is, in the state where the water soluble protective film 17 has been removed, as shown in FIG. 6, the upper surface of the semiconductor wafer 21 in the regions of the dicing streets 22 and the regions on opposite sides of the streets is exposed via the grooves 23. Moreover, portions of the four layers of the low dielectric films 4, the passivation film 7 and the protective film 9 laminated on the semiconductor wafer 21 are separated from one another by the grooves 23. In consequence, a plurality of low dielectric film wiring line laminated structure portions 3 independent of one another are formed on the wafer 21, as shown in FIG. 1.

As one example, a width of the groove 23 is 10 to 1000 µm × 2 plus a width of the dicing street (a dicing cutter) 22. As a result in the completed device shown in FIG. 1, a width of the portion of the sealing film 14 which covers the side surfaces of the low dielectric film wiring line laminated structure portion 3, the passivation film 7 and the protective film 9 is 10 to 1000 µm.

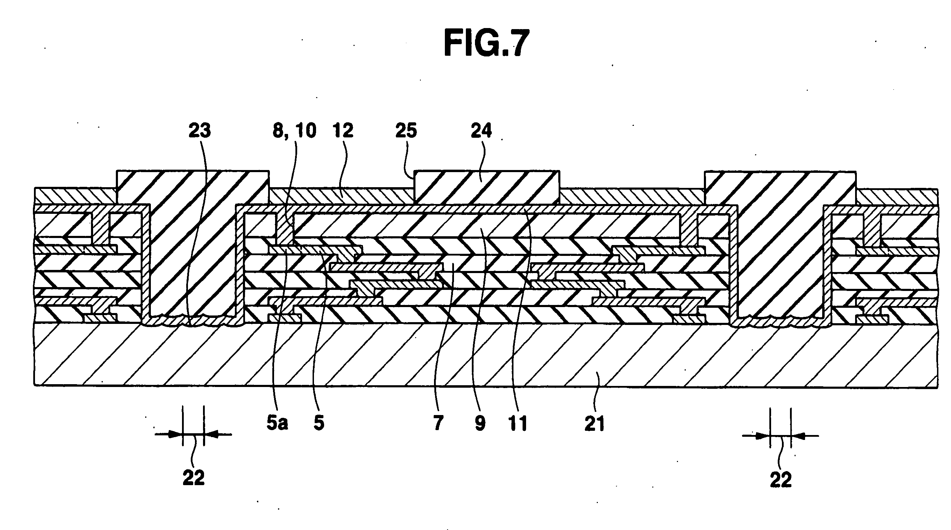

Next, as shown in FIG. 7, the metallic underlayers 11 are formed on the upper surfaces of the connection pad portions 5a of the wiring lines 5 of the uppermost layer exposed via the openings 8, 10 of the passivation film 7 and the protective film 9, on the portions of the upper surface of the semiconductor wafer 21 exposed via the grooves 23, and on the whole upper surface of the protective film 9. In this case, the metallic underlayers 11 may be formed by an only copper layer formed by electroless plating, an only copper layer formed by sputtering, or a copper layer formed by the sputtering on a thin film layer of titanium or the like formed by the sputtering.

Next, plating resist films 24 are formed on the upper surfaces of the metallic underlayers 11, and followed by patterning. As a result, openings 25 are formed in portions of the plating resist films 24 corresponding to regions in which the upper layer wiring lines 12 are formed. Next, electrolytic plating of copper is performed by use of the metallic underlayers 11 as plating current paths to thereby form the upper layer wiring lines 12 on the upper surfaces of the metallic underlayers 11 in the openings 25 of the plating resist films 24. Next, the plating resist films 24 are peeled.

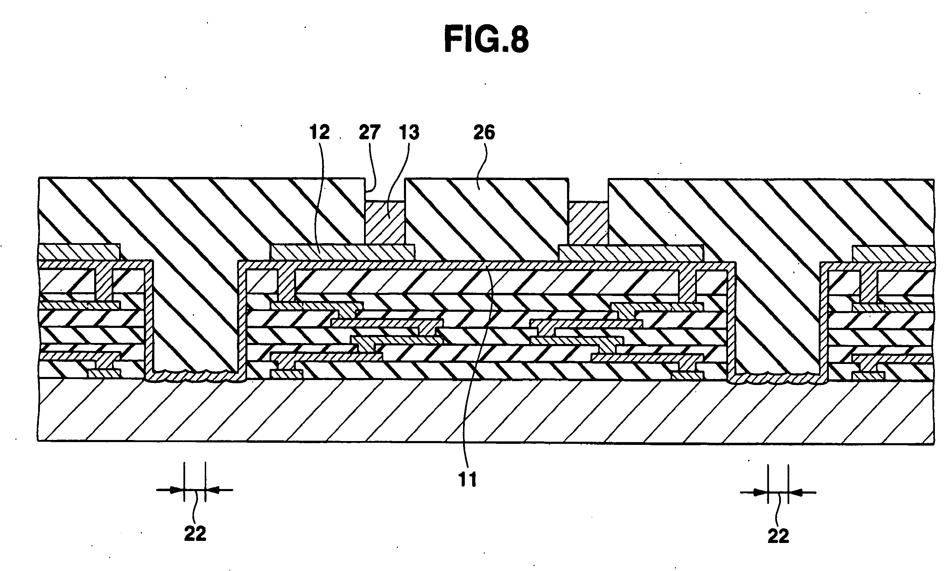

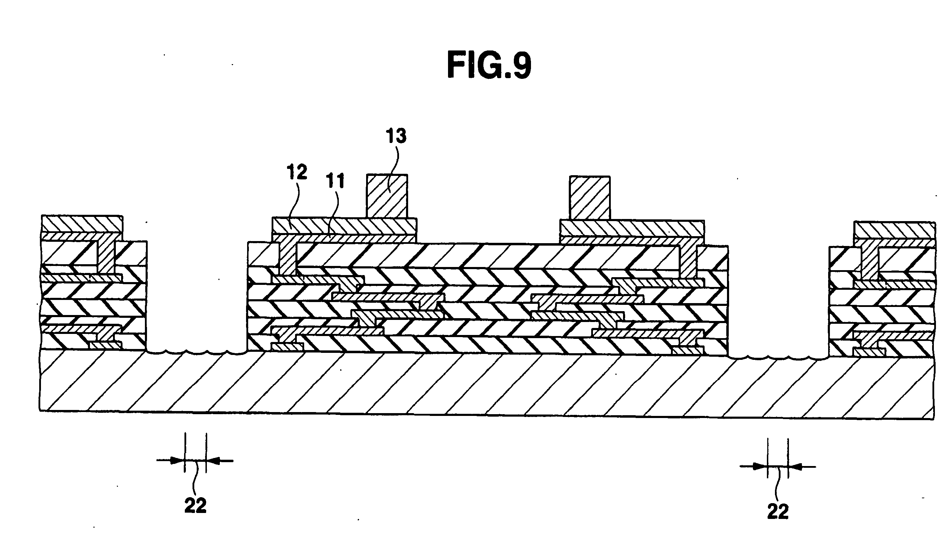

Next, as shown in FIG. 8, on the upper surfaces of the metallic underlayers 11 and the upper layer wiring lines 12, a plating resist film 26 is formed by depositing and then patterning. Thus, in this case, openings 27 are formed in the plating resist film 26 in portions corresponding to the connection pad portions (regions where the columnar electrodes 13 are formed) of the upper layer wiring lines 12. Next, the electrolytic plating of copper is performed by use of the metallic underlayers 11 as the plating current paths, whereby the columnar electrodes 13 each having a height of 50 to 150 µm are formed on the upper surfaces of the connection pad portions of the upper layer wiring lines 12 in the openings 27 of the plating resist film 26. Next, the plating resist film 26 is entirely peeled or removed. Then, unnecessary portions of the metallic underlayers 11 are etched and removed by use of the upper layer wiring lines 12 as masks. Consequently, as shown in FIG. 9, the metallic underlayers 11 only under the upper layer wiring lines 12 are left.

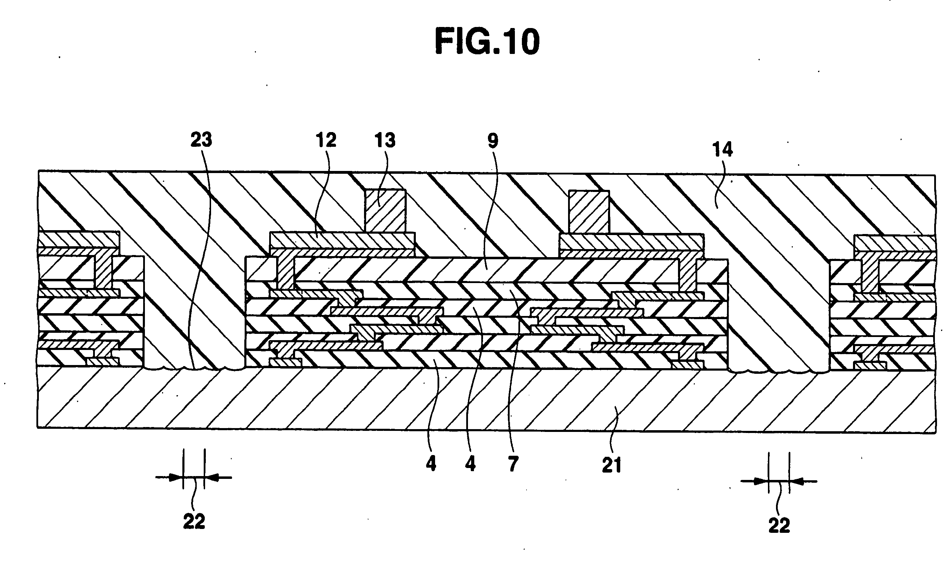

Next, as shown in FIG. 10, by a screen printing process, a spin coating process or the like, the sealing film (organic resin film) 14 made of an organic material such as an epoxy-based resin is entirely formed on the upper surfaces of the upper layer wiring lines 12, the columnar electrodes 13 and the protective film 9, as well as on the upper surface of the semiconductor wafer 21 exposed via the grooves 23 so that a thickness of the sealing film 14 is larger than a height of the columnar electrodes 13. Therefore, in this state, the upper surfaces of the columnar electrodes 13 are covered with the sealing film 14. The side surfaces of the protective film 9, the passivation film 7 and four layers of the low dielectric films 4 are also entirely covered with the sealing film 14.

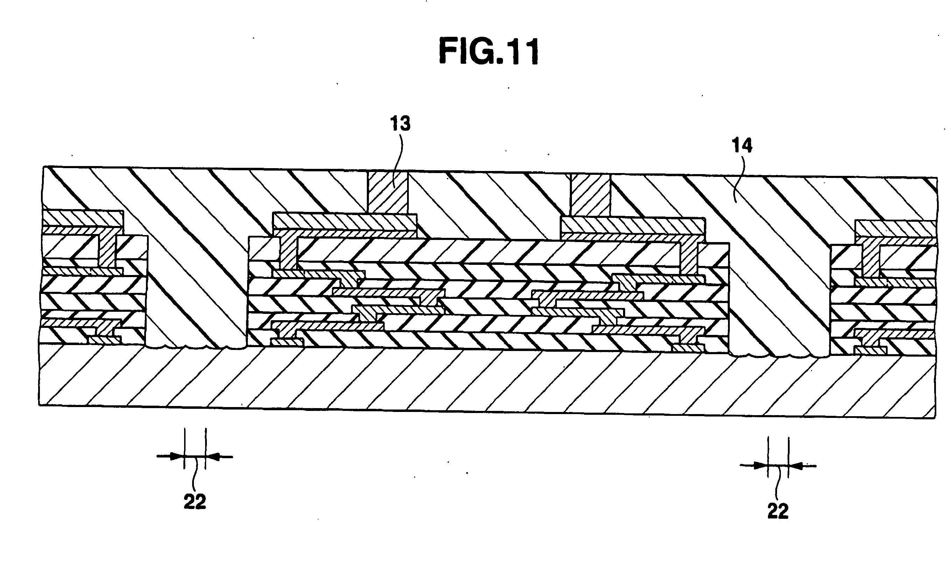

Next, a portion of the upper surface of the sealing film 14 is appropriately ground to expose the upper surfaces of the columnar electrodes 13 as shown in FIG. 11. Moreover, the exposed upper surfaces of the columnar electrodes 13 and the upper surface of the sealing film 14 are flattened so that these upper surfaces are on one plane. In flattening this upper surface of the sealing film 14, upper surface portions of the columnar electrodes 13 may be ground together with the upper portion of the sealing film 14 as much as several to ten or more micrometers.

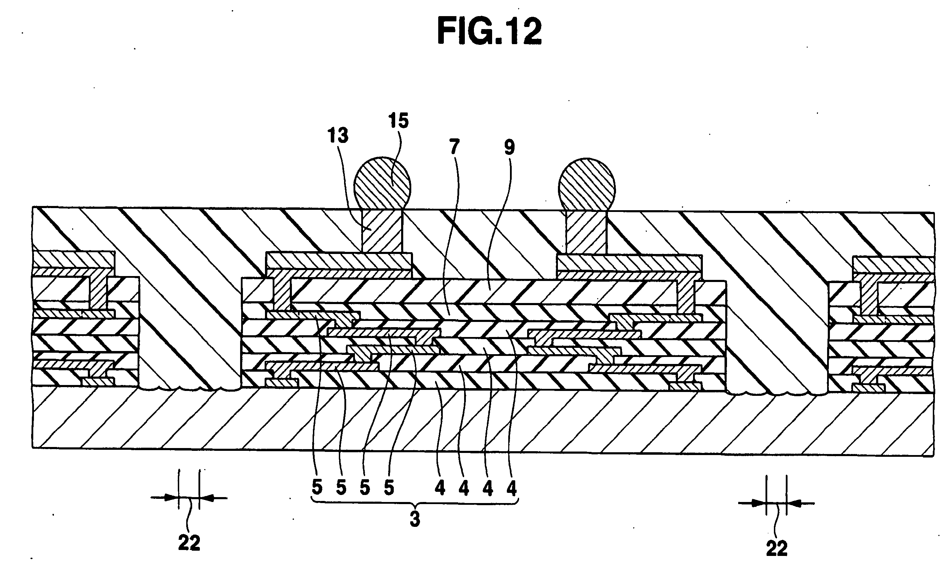

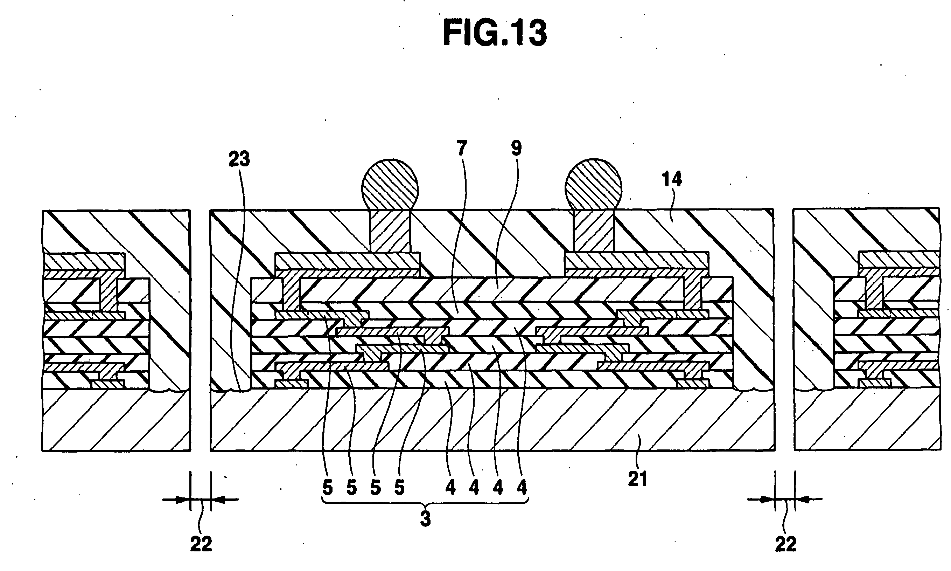

Next, as shown in FIG. 12, the solder balls 15 are formed on the upper surfaces of the columnar electrodes 13. Next, as shown in FIG. 13, the sealing film 14 and the semiconductor wafer 21 are cut along the dicing streets 22 in the centers of the grooves 23. As described above, since the grooves 23 have been formed to be wider than the dicing streets 22, there are obtained a plurality of semiconductor devices each having a structure in which, as shown in FIG. 1, the side surfaces of the low dielectric film wiring line laminated structure portion 3 are covered with the sealing film 14, and further the side surfaces of the passivation film 7 and the upper surface and the side surfaces of the protective film 9 are also covered with the sealing film 14.

In the above embodiment, the exposed part of the upper surface of the semiconductor wafer 21 is shown like a bottom portion of the groove 23, but the upper surface of the semiconductor wafer 21 may be partially removed by a laser beam to form the groove 23, so that the bottom portion of the groove 23 may be below the upper surface of the semiconductor wafer 21. If an insulating film such as a field oxide film is formed on the upper surface of the semiconductor wafer 21, the upper surface of this field oxide film or an intermediate portion of a film thickness thereof may be the bottom portion of the groove 23, and the bottom portion of the groove 23 may be positioned above the upper surface of the semiconductor wafer 21.

### (First Embodiment)

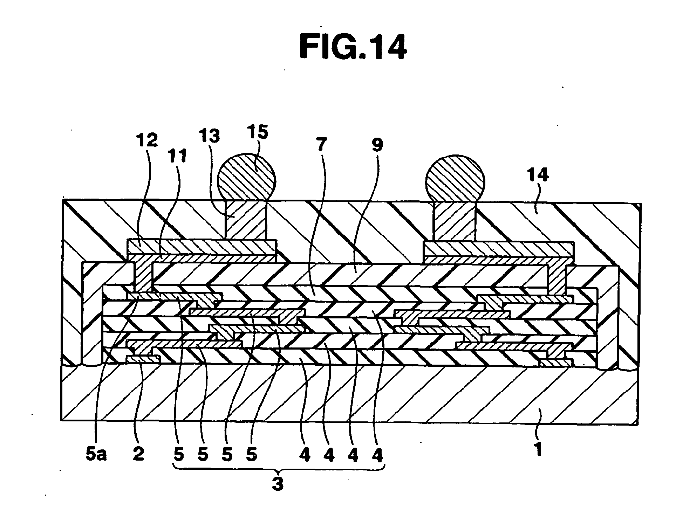

FIG. 14 shows a sectional view of a semiconductor device as a first embodiment of the present invention. This semiconductor device is different from the semiconductor device shown in FIG. 1 in that the upper surface and the side surfaces of the passivation film 7 and the side surfaces of the low dielectric film wiring line laminated structure portion 3 are covered with the protective film 9, and the side surfaces of the protective film 9 is covered with the sealing film 14.

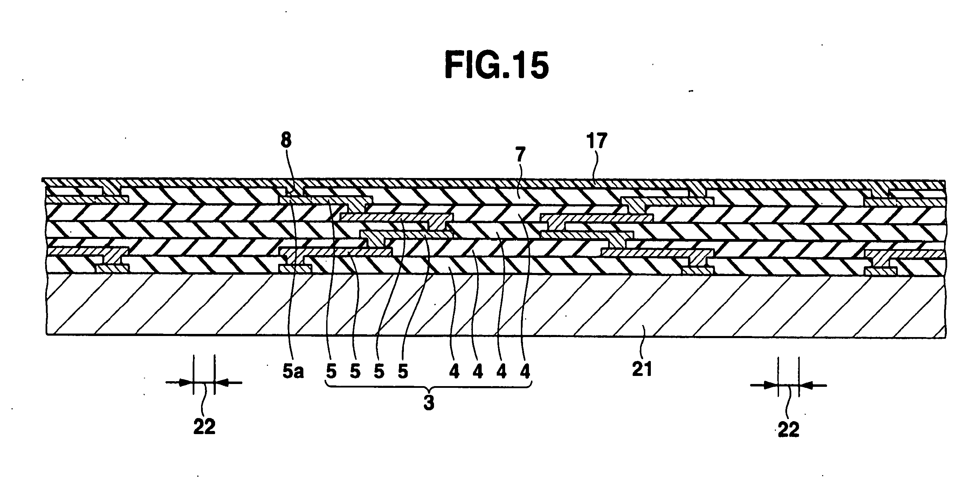

As one example of manufacturing this semiconductor device, an assembly shown in FIG. 2 is prepared. Then, as shown in FIG. 15, the water-soluble protective film 17, made of water-soluble polymers such as polyvinyl alcohol (PVA) or polyacrylamide (PAM), is formed on the upper surface of the passivation film 7 and the connecting pad portions 5a of the wiring lines 5 of the uppermost layer, which are exposed via the opening 8 of the passivation film 7, by a screen printing process, a spin coating process or the like.

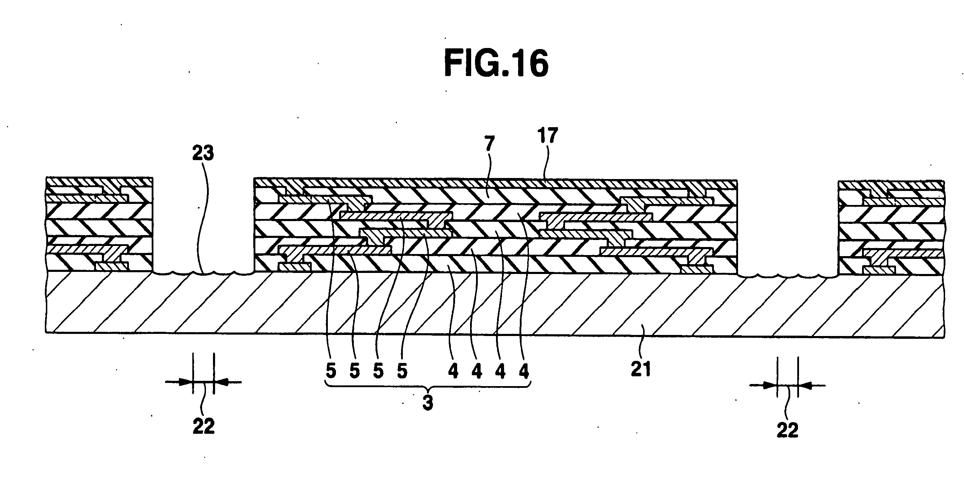

Thereafter, as shown in FIG. 16, by laser processing which emits a laser beam, the grooves 23 are formed in the water soluble protective film 17, the passivation film 7 and four layers of the low dielectric films 4 in regions of the dicing streets 22 and regions on opposite sides of the streets. In this process also, when the laser beam is radiated on the low dielectric films 4, the low dielectric films 4 melt and scatter as low dielectric film pieces. The scattered low dielectric film pieces drop on and stick into the upper surface of the water soluble protective film 17, not the upper surface of the passivation film 7. Then, when the water soluble protective film 17 is washed with water and removed, the low dielectric film pieces stuck into the upper surface of the water soluble protective film 17 are also removed simultaneously. In this case also, if the scattered low dielectric film pieces are sucked by evacuation, the water soluble protective film 17 may be unnecessary.

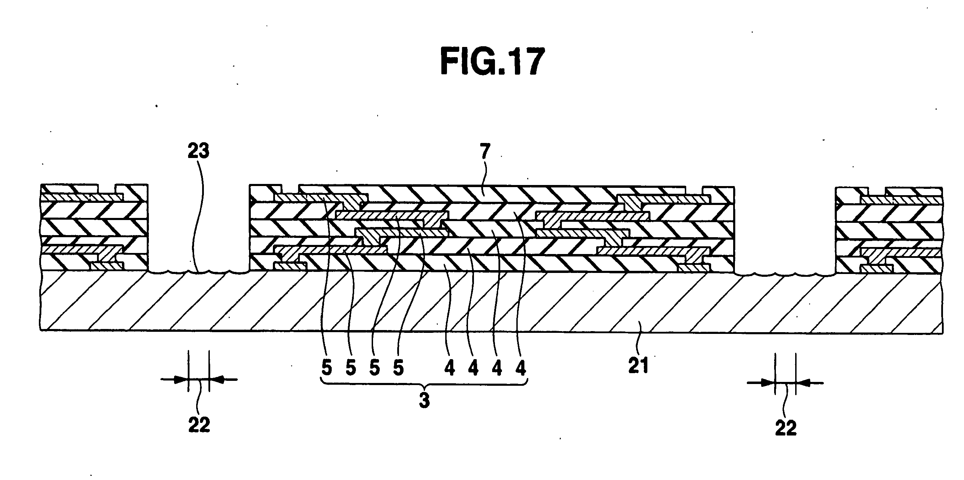

In this state, that is, in the state where the water soluble protective film is removed as shown in FIG. 17, the upper surfaces of the semiconductor wafer 21 in the dicing streets 22 and the regions on opposite sides of the streets are exposed via the grooves 23. Moreover, units which are laminated on the semiconductor wafer 21 and which are each constituted of four layers of the low dielectric films 4 and the passivation film 7 are separated from one another along the grooves 23. In consequence, a plurality of low dielectric film wiring line laminated structure portions 3 shown in FIG. 14 are formed on the semiconductor wafer 21.

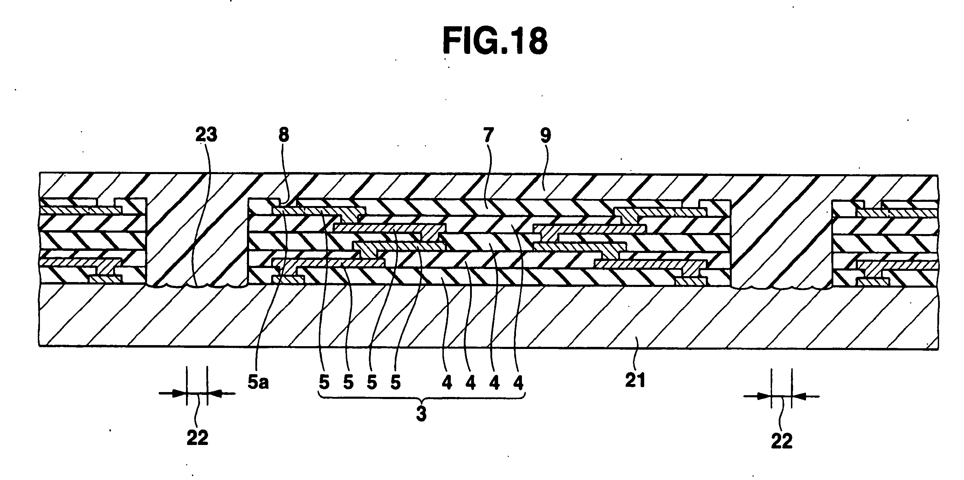

Next, as shown in FIG. 18, by a screen printing process, a spin coating process or the like, the protective film (organic resin film) 9 made of an organic material such as a polyimide-based resin is formed on the upper surfaces of the connection pad portions 5a of the wiring lines 5 of the uppermost layer exposed via the openings 8 of the passivation film 7, on the upper surface of the passivation film 7, and on the upper surfaces of portions of the semiconductor wafer 21 exposed via the grooves 23. It is preferable that the upper surface of the passivation film 7 and the protective film 9 formed in the grooves 23 have substantially flat surfaces.

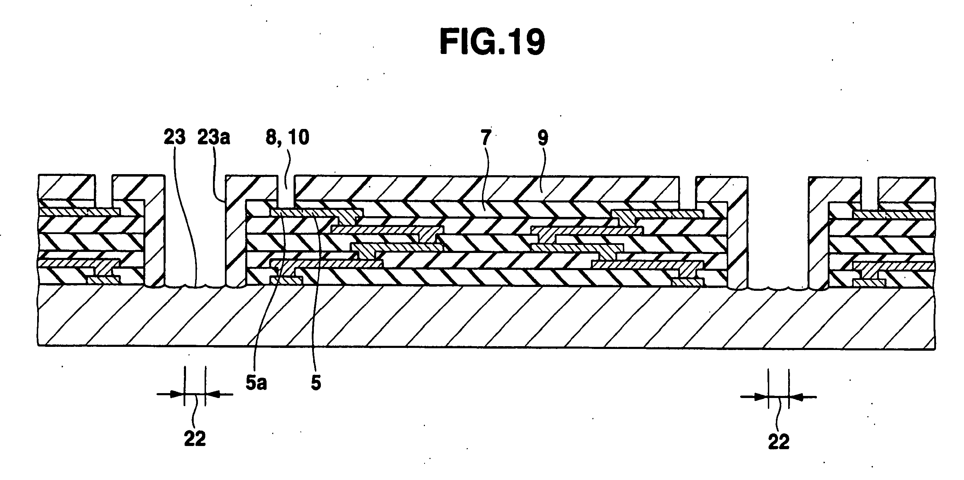

Next, as shown in FIG. 19, by laser processing which emits a laser beam or photolithography, grooves 23a slightly narrower than the aforementioned grooves 23 are formed in the protective film 9 in the regions of the dicing streets 22 and the regions on opposite sides of the streets, and openings 8 and 10 are formed in portions of the passivation film 7 and the protective film 9 corresponding to the connecting pad portions 5a of the wiring lines 5 in the uppermost layer. Since the subsequent steps are similar to the steps of FIG. 7 et seq. of the first example, description thereof is omitted.

### (Second Embodiment)

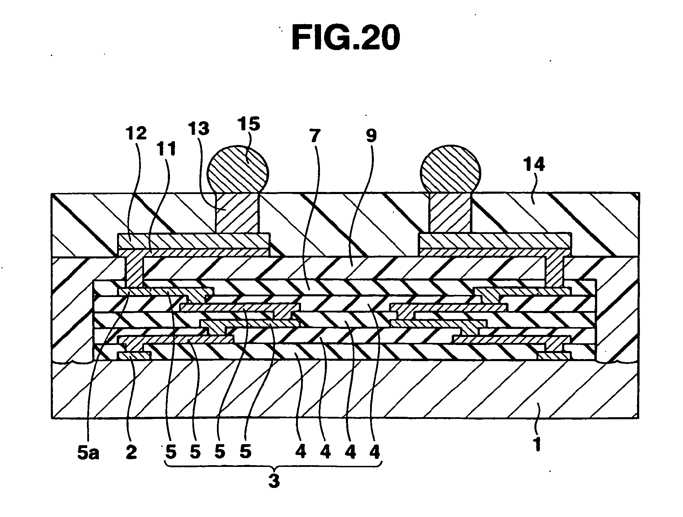

FIG. 20 shows a sectional view of a semiconductor device as a second embodiment of the present invention. The second embodiment is different from the semiconductor device shown in FIG. 14 in that the protective film (organic resin film) 9 which covers the upper surface and the side surfaces of the passivation film 7 and the side surfaces of the low dielectric film wiring line laminated structure portions 3 is extended to the same plane as that of the side surface of the silicon substrate 1.

To produce the above semiconductor device, the groove 23 is completely filled with a part of the protective film 9, as shown in FIG. 18, so that the groove 23a as shown in FIG. 19 may not be formed. In this case, therefore, the sealing film 14, the protective film 9 and the semiconductor wafer 21 are cut along the dicing streets 22 in the last step.

### Second Example

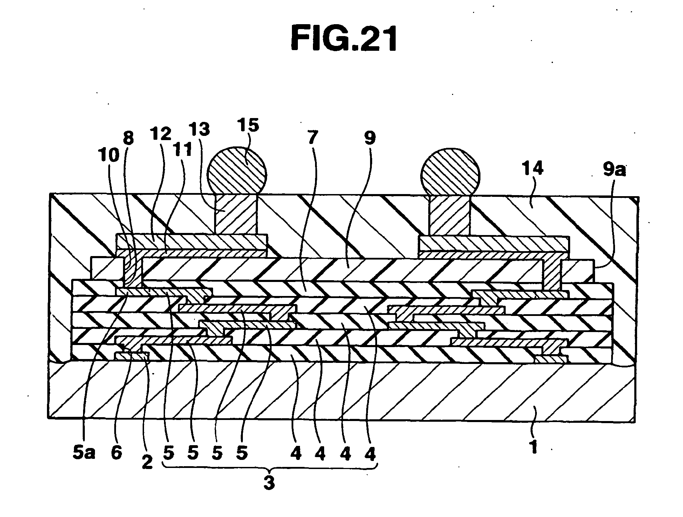

FIG. 21 is a sectional view of a semiconductor device . This semiconductor device is different from the semiconductor device shown in FIG. 1 in that the outer side surfaces 9a of the protective film 9 are located inward from the outer side surfaces of the low dielectric film wiring line laminated structure portion 3 and the passivation film 7. In other words, the protective film 9 is formed on the passivation film 7 to be smaller than the passivation film 7 in a plane size. In this case, each of the outer side surfaces of the passivation film 7 and each of the low dielectric film wiring line laminated structure portion 3 substantially form one plane (vertical plane in FIG. 21).

An example of the method for manufacturing the semiconductor device will be described. For example, as shown in FIG. 3, the protective film (organic resin film) 9 is formed on the entire surface of the passivation film 7. Then, the protective film 9 is patterned by means of photolithography, thereby forming the protective film as shown in FIG. 21. The patterning of the protective film 9 is carried out such that a side surface 9a may not reach the dicing line 22. The side surface 9a of the protective film 9 is deviated from the side surfaces of the passivation film 7 and the low dielectric film wiring line limited structure portion 3 by a distance greater than a positioning deviation that may occur in the next step of laser radiation. Thereafter, the water soluble protective film may be formed on the entire surface, if necessary, and laser beams are applied to the passivation film 7 and the low dielectric film wiring line laminated structure portion 3, making grooves 23.

Another example of the method for manufacturing the semiconductor device will be described. In this example, as shown in FIG. 17, before the protective film 9 is formed, the laser beams are applied to the passivation film 7 and the low dielectric film 4, thereby forming the grooves 23. Then, as shown in FIG. 18, after the laser beams are applied to form the grooves 23, the protective film 9 is patterned. Next, the protective film 9 is formed on the entire surface of the passivation film 7 including the insides of the grooves 23 by spin coating or the like. Then, the protective film 9 is patterned by means of photolithography so as to remove those parts of the protective film 9 in the grooves 23 and peripheries of the passivation film 23, thereby forming the protective film as shown in FIG. 21.

In both the above examples of the method for manufacturing the semiconductor device, the passivation film 7 and the low dielectric film 4 are processed with the laser beams, and the protective film 9 is not. Therefore, this method is particularly effective in the case where the protective film 9 is made of a material, such as a polyimide-based resin, which easily absorbs laser energy and cannot be easily cut by radiation of laser beams.

### Third Example

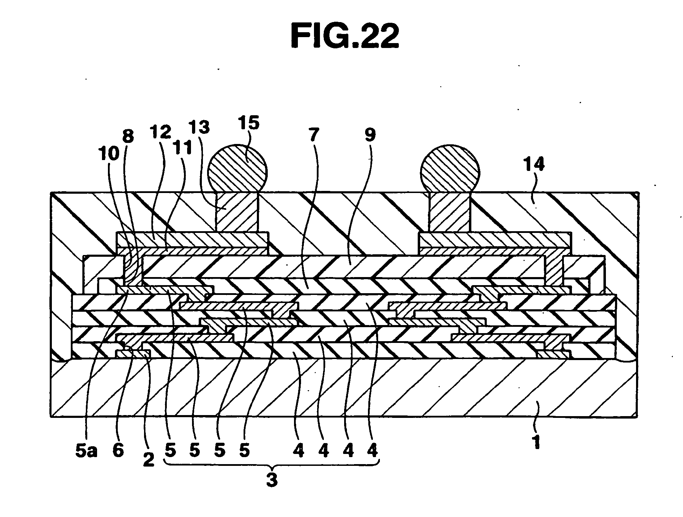

FIG. 22 is a sectional view of a semiconductor device . This semiconductor device is different from the semiconductor device shown in FIG. 21 in that the outer side surfaces of the passivation film 7 are located inward from those of the protective film 9. In other words, the passivation film 7 is formed on the low dielectric film wiring line laminated structure portion 3 to be smaller than the protective film 9 in a plane size, and the protective film 9 has side portions downwardly extending to cover the side surfaces of the passivation film 7.

To manufacture this semiconductor device, the passivation film 7 is formed on the overall surface of the low dielectric film 4 of the uppermost layer, as shown in FIG. 2. Then, the passivation film 7 is patterned by means of photolithography. Thereafter, the protective film 9 is formed on the passivation film 7 and parts of the low dielectric film 4 of the uppermost layer which are not covered by the passivation film 7. Thereafter, the protective film 9 is patterned by means of photolithography. Then, if necessary, the water soluble protective film may be formed on the entire surface, and the low dielectric film 4 is processed by radiation of laser beams, thereby forming grooves 23.

In the above method for manufacturing the semiconductor device, only the low dielectric film 4 is processed with laser beams, and the passivation film 7 and the protective film 9 are not. Optimal laser-beam process conditions can therefore be set for the processing of the low dielectric film 4. Hence, the low dielectric film 4 can be processed efficiently with high precision. It is to be noted that the passivation film 7 may be of the same size as the protective film 9, so that the side surfaces of the passivation film 7 and the side surfaces of the protective film 9 form substantially the same plane.

### Fourth Example

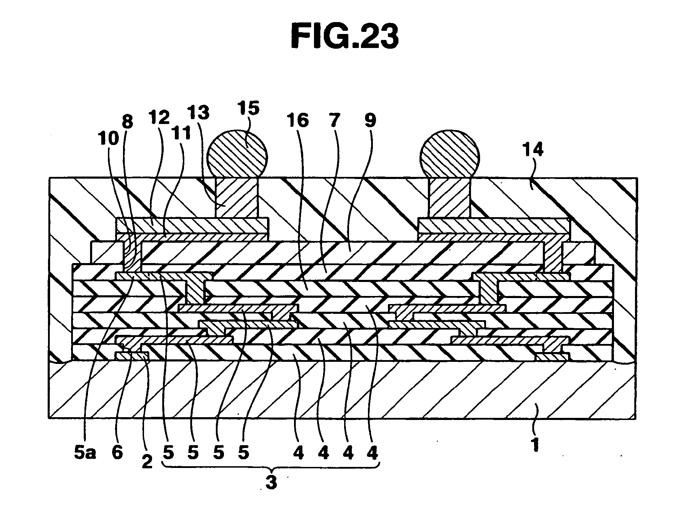

FIG. 23 is a sectional view of a semiconductor device . This semiconductor device is different from the semiconductor device shown in FIG. 21 in that the low dielectric film wiring line laminated structure portion 3 has a lower passivation film 16 between the uppermost wiring line 5 and the uppermost low dielectric film 4.

In this case, the upper passivation film 7 and the lower passivation film 16 may be formed of the same inorganic material, such as silicon oxide. Alternatively, the passivation film 7 may be formed of silicon nitride, while the lower passivation film 16 may be formed of silicon oxide.

### Other Examples

For example, in the first example, after the process shown in FIG. 3, the metallic underlayers 11 may be formed on the entire upper surface of the protective film 9. Then, the upper wiring lines 12 and the columnar electrodes 13 may be formed by electrolytic plating. Then, unnecessary portions of the metallic underlayers 11 may be etched and removed by use of the upper layer wiring lines 12 as masks. Thereafter, the water soluble protective film may be formed on the entire surface, if necessary, and laser beams are applied to the protective film 9, the passivation film 7 and the low dielectric film 4, making grooves 23. In this case, if the water soluble protective film is removed after forming the grooves 23, the structure as shown in FIG. 9 can be obtained.

Referring to FIG. 21, for example, the uppermost low dielectric film 4 of the low dielectric film wiring line limited structure portion 3 may be a lower passivation film. In other words, the low dielectric film wiring line limited structure portion 3 may have a lower passivation film formed between the uppermost wiring line 5 and the second uppermost wiring line 5.

In this case, the passivation film 7 and the lower passivation film may be formed of the same inorganic material, such as silicon oxide. Alternatively, the passivation film 7 may be formed of silicon nitride, while the lower passivation film may be formed of silicon oxide.

In the above embodiments and examples, the upper wiring lines 12 are formed on the protective film 9 and the columnar electrodes 13 are formed on the connection pad portion on the upper wiring lines 12. However, this is applicable to a structure in which only the connection pad portion is formed on the protective film 9 and bump electrodes for external connection, such as solder balls 15, are formed on the connection pad portion.

As described above, the low dielectric film wiring line laminated structure portion having a laminated structure of the low dielectric films, which has a relative dielectric constant of 3.0 or lower and a glass transition temperature of 400°C or higher, and the wiring lines are provided in regions excluding the peripheral portions of the semiconductor substrate. The side surfaces of the low dielectric film wiring line laminated structure portion are covered by one of the insulating film formed of organic resin or the sealing film. Therefore, the problem of peeling of the low dielectric films can be significantly avoided.

## Claims

1. A semiconductor device comprising:
a semiconductor substrate (1);
a low dielectric film wiring line laminated structure portion (3) provided in regions excluding peripheral portions of one surface of the semiconductor substrate (1), and the low dielectric film wiring line laminated structure portion (3) constitutes a laminated structure including a plurality of low dielectric films (4) and a plurality of wiring lines (5), each of the low dielectric films having a relative dielectric constant of 3.0 or lower and a glass transition temperature of 400°C or higher;
an insulating film covering the upper surface of the low dielectric film wiring line laminated structure portion (3);
a connection pad portion for an electrode, said connection pad portion for an electrode being arranged on said insulating film (9) provided on the low dielectric film wiring line laminated structure portion (3), whereby said connection pad portion for an electrode is connected to a connection pad portion (5a) of an uppermost wiring line (5) of the low dielectric film wiring line laminated structure portion (3);
a bump electrode (13) for external connection, provided on the connection pad portion for the electrode; and
a sealing film (14) made of an organic resin and provided at least on a part of the insulating film (9) to surround the bump electrode (13) for the external connection,
**characterized in that** the side surfaces of the low dielectric film wiring line laminated structure portion (3) are also covered with the insulating film (9).

2. The semiconductor device according to claim 1, further comprising a passivation film (7) made of an inorganic material between the insulating film (9) and the low dielectric film wiring line laminated structure portion (3).

3. The semiconductor device according to claim 2, wherein corresponding side surfaces of the insulating film (9), the passivation film (7) and the low dielectric film wiring line laminated structure portion (3) form one plane, and the side surfaces of the insulating film (9), the passivation film (7) and the low dielectric film wiring line laminated structure portion (3) are covered with the sealing film (14).

4. The semiconductor device according to claim 2, wherein corresponding side surfaces of the passivation film (7) and the low dielectric film wiring line laminated structure portion (3) form one plane, and the side surfaces of the passivation film (7) and the low dielectric film wiring line laminated structure portion (3) are covered with the insulating film (9).

5. The semiconductor device according to claim 2, wherein the side surfaces of the insulating film (9) are located inward from the side surfaces of the low dielectric film wiring line laminated structure portion (3).

6. The semiconductor device according to claim 5, wherein the side surfaces of the passivation film (7) are located inward from the corresponding side surfaces of the insulating film (9).

7. The semiconductor device according to claim 5, wherein the corresponding side surfaces of the insulating film (9) and the passivation film (7) form one plane.

8. The semiconductor device according to claim 1, wherein the low dielectric film wiring line laminated structure portion (3) has a lower passivation film (16) formed between the uppermost wiring line (5) and an uppermost low dielectric film (4).

9. The semiconductor device according to any one of claims 1 to 8, wherein the low dielectric film (14) includes one of a polysiloxane-based material having an Si-O bond and an Si-H bond, a polysiloxane-based material having an Si-O bond and an Si-CH3 bond, a carbon-doped silicon oxide and an organic polymer-based low-k material, or a porous type of one of a fluorine-doped silicon oxide, boron-doped silicon oxide and silicon oxide.

10. A method of manufacturing a semiconductor device, comprising:
preparing a semiconductor wafer (21), on one surface of which a low dielectric film wiring line laminated structure portion (3) is formed, the low dielectric film wiring line laminated structure portion (3) including low dielectric films (4) and wiring lines (5), the low dielectric films having a relative dielectric constant of 3.0 or lower and a glass transition temperature of 400°C or higher; and
removing parts of the low dielectric film wiring line laminated structure portion (3) in regions above dicing streets (22) and regions on opposite sides of the dicing streets by applying laser beams, and forming a groove (23) exposing side surfaces of the low dielectric film wiring line laminated structure portion (3);
forming an insulating film (9) covering an upper surface and the side surfaces of the low dielectric film wiring line laminated structure portion (3); and forming a bump electrode (13) for the external connection on the pad connected with a connection pad portion (5a) of an uppermost wiring line (5) of the low dielectric film wiring line laminated structure portion (3),
forming a sealing film (14) made of an organic resin on the insulating film (9) to surround the bump electrode (13) for the external connection, and
cutting the insulating film (9), the sealing film (14) formed on the insulating film (9) and the semiconductor wafer (21) along the dicing streets (22), thereby obtaining a plurality of semiconductor devices.

11. The method for manufacturing a semiconductor device according to claim 10, wherein the forming a groove (23) includes forming a water soluble protective film (17) entirely on the organic resin film (9) before forming the groove (23), and removing the water soluble protective film (17) after forming the groove (23).

12. The method for manufacturing a semiconductor device according to claim 10, wherein the forming the organic resin film (9, 14) includes forming an insulating film (9) made of organic resin covering an upper portion of the low dielectric film wiring line laminated structure portion (3).

13. The method for manufacturing a semiconductor device according to claim 12, further comprising:
forming a connecting pad portion for an electrode on the insulating film (9) so as to be connected to a connection pad portion of an uppermost wiring line (5) of the low dielectric film wiring line laminated structure portion (3); and
forming a bump electrode (13) for external connection on the connection pad portion for the electrode.

14. The method for manufacturing a semiconductor device according to claim 10, wherein the preparing a semiconductor wafer (21), on one surface of which a low dielectric film wiring line laminated structure portion (3) is formed, includes preparing the low dielectric film wiring line laminated structure portion (3) on which an insulating film (9) made of organic resin is formed, and the forming a groove includes removing parts of the insulating film (9) and the low dielectric film wiring line laminated structure portion (3) in the regions above the dicing streets (22) and the regions on the opposite sides of the dicing streets by applying laser beams and forming the groove (23) exposing side surfaces of the insulating film (9) and the low dielectric film wiring line laminated structure portion (3).

15. The method for manufacturing a semiconductor device according to claim 10, wherein the preparing a semiconductor wafer (21), on one surface of which a low dielectric film wiring line laminated structure portion (3) is formed, includes preparing the low dielectric film wiring line laminated structure portion (3) on which a passivation film (7) is formed, and the forming a groove (23) includes removing parts of the passivation film (7) and the low dielectric film wiring line laminated structure portion (3) in the regions above the dicing streets (22) and the regions on the opposite sides of the dicing street, and forming the groove (23) exposing side surfaces of the passivation film (7) and the side surfaces of the low dielectric film wiring line laminated structure portion (3).

16. The method for manufacturing a semiconductor device according to claim 15, wherein the forming an organic resin film (9, 14) includes forming an insulating film (9, 14) made of an organic resin covering an upper surface of the passivation film (7) and the side surfaces of the passivation film (7) and the side surfaces of the low dielectric film wiring line laminated structure portion (3) exposed through the groove (23).

17. The method for manufacturing a semiconductor device according to claim 16, wherein the forming an insulating film (9, 14) includes patterning the insulating film (9, 14) to prevent the insulating film (9, 14) from extending above the dicing street (22).

18. The method for manufacturing a semiconductor device according to claim 17, wherein the forming an insulating film (9, 14) includes forming the insulating film (9) on the low dielectric film wiring line laminated structure portion (3) and in the groove (3) and patterning the insulating film (9) such that side surfaces of the insulating film (9) are located inward from the side surfaces of the low dielectric film wiring line laminated structure portion (3).

19. The method for manufacturing a semiconductor device according to claim 10, wherein the preparing a semiconductor wafer (21), on one surface of which a low dielectric film wiring line laminated structure portion (3) is formed, includes patterning the insulating film (14) on the low dielectric film wiring line laminated structure portion (3) to prevent the insulating film (14) made of an organic resin from extending above the dicing street (22).

20. The method for manufacturing a semiconductor device according to claim 10, further comprising:
forming a connecting pad portion for an electrode on the insulating film (9) so as to be connected to a connection pad portion of an uppermost wiring line (5) of the low dielectric film wiring line laminated structure portion (3); and
forming a bump electrode (13) for external connection on the connection pad portion for the electrode,
wherein the forming an organic resin film (9, 14) includes forming an insulating film (9) made of an organic resin on the low dielectric film wiring line laminated structure portion (3) and forming a sealing film (14) made of an organic resin covering an upper surface of the insulating film (9) around the bump electrode (13) for external connection, side surfaces of the insulating film (9) and the side surfaces of the low dielectric film wiring line laminated structure portion (3).

## Patentansprüche

1. Halbleiter-Vorrichtung, die umfasst:
ein Halbleiter-Substrat (1);
einen Abschnitt (3) mit einer geschichteten Struktur aus Filmen mit niedriger Dielektrizitätskonstante und Leiterbahnen, der in Bereichen vorhanden ist, die Randabschnitte einer Fläche des Halbleiter-Substrats (1) ausschließen, wobei der Abschnitt (3) mit einer geschichteten Struktur aus Filmen mit niedriger Dielektrizitätskonstante und Leiterbahnen eine geschichtete Struktur bildet, die eine Vielzahl von Filmen (4) mit niedriger Dielektrizitätskonstante und eine Vielzahl von Leiterbahnen (5) enthält, wobei jeder der Filme mit niedriger Dielektrizitätskonstante eine relative Dielektrizitätskonstante von 3,0 oder niedriger und eine Glasübergangstemperatur von 400° C oder höher hat;
einen Isolier-Film, der die obere Fläche des Abschnitts (3) mit einer geschichteten Struktur aus Filmen mit niedriger Dielektrizitätskonstante und Leiterbahnen abdeckt;
einen Kontaktinsel-Abschnitt für eine Elektrode, wobei der Kontaktinsel-Abschnitt für eine Elektrode auf dem Isolier-Film (9) angeordnet ist, der auf dem Abschnitt mit einer geschichteten Struktur aus Filmen mit niedriger Dielektrizitätskonstante und Leiterbahnen vorhanden ist, und der Kontaktinsel-Abschnitt für eine Elektrode mit einem Kontaktinsel-Abschnitt (5a) einer obersten Leiterbahn (5) des Abschnitts (3) mit einer geschichteten Struktur aus Filmen mit niedriger Dielektrizitätskonstante und Leiterbahnen verbunden ist;
eine Bump-Elektrode (13) für externen Anschluss, die an dem Kontaktinsel-Abschnitt für die Elektrode vorhanden ist; und
einen Abdicht-Film (14), der aus einem organischen Kunststoff besteht und auf wenigstens einem Teil des Isolier-Films (9) so vorhanden ist, dass er die Bump-Elektrode (13) für den externen Anschluss umgibt,
**dadurch gekennzeichnet, dass** die Seitenflächen des Abschnitts (3) mit einer geschichteten Struktur aus Filmen mit niedriger Dielektrizitätskonstante und Leiterbahnen ebenfalls mit dem Isolier-Film (9) abgedeckt sind.

2. Halbleiter-Vorrichtung nach Anspruch 1, die des Weiteren einen Passivierungs-Film (7), der aus anorganischem Material besteht, zwischen dem Isolier-Film (9) und dem Abschnitt (3) mit einer geschichteten Struktur aus Filmen mit niedriger Dielektrizitätskonstante und Leiterbahnen umfasst.

3. Halbleiter-Vorrichtung nach Anspruch 2, wobei entsprechende Seitenflächen des Isolier-Films (9), des Passivierungs-Films und des Abschnitts (3) mit einer geschichteten Struktur aus Filmen mit niedriger Dielektrizitätskonstante und Leiterbahnen eine Ebene bilden und die Seitenflächen des Isolier-Films (9), des Passivierungs-Films (7) und des Abschnitts (3) mit einer geschichteten Struktur aus Filmen mit niedriger Dielektrizitätskonstante und Leiterbahnen mit dem Abdicht-Film (14) abgedeckt sind.

4. Halbleiter-Vorrichtung nach Anspruch 2, wobei entsprechende Seitenflächen des Passivierungs-Films (7) und des Abschnitts (3) mit einer geschichteten Struktur aus Filmen mit niedriger Dielektrizitätskonstante und Leiterbahnen eine Ebene bilden und die Seitenflächen des Passivierungs-Films (7) sowie des Abschnitts (3) mit einer geschichteten Struktur aus Filmen mit niedriger Dielektrizitätskonstante und Leiterbahnen mit dem Isolier-Film (9) abgedeckt sind.

5. Halbleiter-Vorrichtung nach Anspruch 2, wobei sich die Seitenflächen des Isolier-Films von den Seitenflächen des Abschnitts (3) mit einer geschichteten Struktur aus Filmen mit niedriger Dielektrizitätskonstante und Leiterbahnen aus innen befinden.

6. Halbleiter-Vorrichtung nach Anspruch 5, wobei sich die Seitenflächen des Passivierungs-Films (7) von den entsprechenden Seitenflächen des Isolier-Films (9) aus innen befinden.

7. Halbleiter-Vorrichtung nach Anspruch 5, wobei die entsprechenden Seitenflächen des Isolier-Films (9) und des Passivierungs-Films (7) eine Ebene bilden.

8. Halbleiter-Vorrichtung nach Anspruch 1, wobei der Abschnitt (3) mit einer geschichteten Struktur aus Filmen mit niedriger Dielektrizitätskonstante und Leiterbahnen einen unteren Passivierungs-Film (16) aufweist, der zwischen der obersten Leiterbahn (5) und einem obersten Film (4) mit niedriger Dielektrizitätskonstante ausgebildet ist.

9. Halbleiter-Vorrichtung nach einem der Ansprüche 1 bis 8, wobei der Film (14) mit niedriger Dielektrizitätskonstante ein Material auf Basis von Polysiloxan mit einer Si-O-Bindung und einer Si-H-Bindung, ein Material auf Basis von Polysiloxan mit einer Si-O-Bindung und einer Si-CH₃-Bindung, ein mit Kohlenstoff dotiertes Siliziumoxid oder ein low-k-Material auf Basis von organischem Polymer oder einen porösen Typ eines mit Fluor dotierten Siliziumoxids, eines mit Bor dotierten Siliziumoxids oder eines Siliziumoxids enthält.

10. Verfahren zum Herstellen einer Halbleiter-Vorrichtung, das umfasst:
Fertigen eines Halbleiter-Wafers (21), auf dessen einer Fläche ein Abschnitt (3) mit einer geschichteten Struktur aus Filmen mit niedriger Dielektrizitätskonstante ausgebildet ist, wobei der Abschnitt (3) mit einer geschichteten Struktur aus Filmen mit niedriger Dielektrizitätskonstante und Leiterbahnen Filme (4) mit niedriger Dielektrizitätskonstante sowie Leiterbahnen (5) enthält, und die Filme mit niedriger Dielektrizitätskonstante eine relative Dielektrizitätskonstante von 3,0 oder niedriger sowie eine Glasübergangstemperatur von 400 °C oder höher haben; und
Entfernen von Teilen des Abschnitts (3) mit einer geschichteten Struktur aus Filmen mit niedriger Dielektrizitätskonstante und Leiterbahnen in Bereichen oberhalb von Trennspuren (dicing streets) (22) und Bereichen an gegenüber liegenden Seiten der Trennspuren durch Anwenden von Laserstrahlen und Ausbilden einer Nut (23), die Seitenflächen des Abschnitts (3) mit einer geschichteten Struktur aus Filmen mit niedriger Dielektrizitätskonstante und Leiterbahnen freilegt;
Ausbilden eines Isolier-Films (9), der eine obere Fläche und die Seitenflächen des Abschnitts (3) mit einer geschichteten Struktur aus Filmen mit niedriger Dielektrizitätskonstante und Leiterbahnen abdeckt, und Ausbilden einer Bump-Elektrode (13) für den externen Anschluss an der Kontaktstelle, die mit einem Kontaktinsel-Abschnitt (5a) einer obersten Leiterbahn (5) des Abschnitts (3) mit einer geschichteten Struktur aus Filmen mit niedriger Dielektrizitätskonstante und Leiterbahnen verbunden ist,
Ausbilden eines Abdicht-Films (14), der aus einem organischen Kunststoff besteht, auf dem lsolier-Film (9) so, dass er die Bump-Elektrode für den externen Anschluss umgibt, und
Schneiden des Isolier-Films (9), des auf dem Isolier-Film (9) ausgebildeten Abdicht-Films (14) und des Halbleiter-Wafers (21) entlang der Trennspuren (22), um so eine Vielzahl von Halbleiter-Vorrichtungen zu gewinnen.

11. Verfahren zum Herstellen einer Halbleiter-Vorrichtung nach Anspruch 10, wobei das Ausbilden einer Nut (23) einschließt, dass auf dem gesamten Film (9) aus organischem Kunststoff ein wasserlöslicher Schutzfilm (17) ausgebildet wird, bevor die Nut (23) ausgebildet wird, und der wasserlösliche Schutzfilm (17) nach Ausbilden der Nut (23) entfernt wird.

12. Verfahren zum Herstellen einer Halbleiter-Vorrichtung nach Anspruch 10, wobei das Ausbilden des Films (9, 14) aus organischem Kunststoff Ausbilden eines Isolier-Films (9) einschließt, der aus organischem Kunststoff besteht und einen oberen Abschnitt des Abschnitts (3) mit einer geschichteten Struktur aus Filmen mit niedriger Dielektrizitätskonstante und Leiterbahnen abdeckt.

13. Verfahren zum Herstellen einer Halbleiter-Vorrichtung nach Anspruch 12, das des Weiteren umfasst:
Ausbilden eines Kontaktinsel-Abschnitts für eine Elektrode auf dem Isolier-Film (9), so dass er mit einem Kontaktinsel-Abschnitt einer obersten Leiterbahn (5) des Abschnitts (3) mit einer geschichteten Struktur aus Filmen mit niedriger Dielektrizitätskonstante und Leiterbahnen verbunden ist; und
Ausbilden einer Bump-Elektrode für externen Anschluss an dem Kontaktinsel-Abschnitt für die Elektrode.

14. Verfahren zum Herstellen einer Halbleiter-Vorrichtung nach Anspruch 10, wobei das Fertigen eines Halbleiter-Wafers (21), an dessen einer Fläche ein Abschnitt (3) mit einer geschichteten Struktur aus Filmen mit niedriger Dielektrizitätskonstante und Leiterbahnen ausgebildet ist, Fertigen des Abschnitts (3) mit einer geschichteten Struktur aus Filmen mit niedriger Dielektrizitätskonstante und Leiterbahnen einschließt, auf dem ein aus organischem Kunststoff bestehender Isolier-Film (9) ausgebildet ist, und das Ausbilden einer Nut einschließt, dass Teile des Isolier-Films (9) und des Abschnitts (3) mit einer geschichteten Struktur aus Filmen mit niedriger Dielektrizitätskonstante und Leiterbahnen in den Bereichen oberhalb der Trennspuren (22) und den Bereichen an den gegenüberliegenden Seiten der Trennspuren entfernt werden, indem Laserstrahlen angewendet werden, und die Nut (23) ausgebildet wird, die Seitenflächen des Isolier-Films (9) und des Abschnitts (3) mit einer geschichteten Struktur aus Filmen mit niedriger Dielektrizitätskonstante und Leiterbahnen freilegt.

15. Verfahren zum Herstellen einer Halbleiter-Vorrichtung nach Anspruch 10, wobei das Fertigen eines Halbleiter-Wafers (21), an dessen einer Fläche ein Abschnitt (3) mit einer geschichteten Struktur aus Filmen mit niedriger Dielektrizitätskonstante und Leiterbahnen ausgebildet ist, Fertigen des Abschnitts (3) mit einer geschichteten Struktur aus Filmen mit niedriger Dielektrizitätskonstante und Leiterbahnen einschließt, auf dem ein Passivierungs-Film (7) ausgebildet ist, und das Ausbilden einer Nut einschließt, dass Teile des Passivierungs-Films (7) und des Abschnitts (3) mit einer geschichteten Struktur aus Filmen mit niedriger Dielektrizitätskonstante und Leiterbahnen in den Bereichen oberhalb der Trennspuren (22) und den Bereichen an den gegenüberliegenden Seiten der Trennspur entfernt werden, indem Laserstrahlen angewendet werden, und die Nut (23) ausgebildet wird, die Seitenflächen des Passivierungs-Films (7) und des Abschnitts (3) mit einer geschichteten Struktur aus Filmen mit niedriger Dielektrizitätskonstante und Leiterbahnen freilegt.

16. Verfahren zum Herstellen einer Halbleiter-Vorrichtung nach Anspruch 15, wobei das Ausbilden des Films (9, 14) aus organischem Kunststoff Ausbilden eines Isolier-Films (9, 14) einschließt, der aus einem organischen Kunststoff besteht und eine obere Fläche des Passivierungs-Films (7) sowie die Seitenflächen des Passivierungs-Films (7) und die Seitenflächen des Abschnitts (3) mit einer geschichteten Struktur aus Filmen mit niedriger Dielektrizitätskonstante und Leiterbahnen abdeckt, die über die Nut (23) freiliegen.

17. Verfahren zum Herstellen einer Halbleiter-Vorrichtung nach Anspruch 16, wobei das Ausbilden eines Isolier-Films (9, 14) einschließt, dass der Isolier-Film (9, 14) strukturiert wird, um zu verhindern, dass sich der Isolier-Film (9,14) oberhalb der Trennspur (22) erstreckt.

18. Verfahren zum Herstellen einer Halbleiter-Vorrichtung nach Anspruch 17, wobei das Ausbilden eines Isolier-Films (9, 14) einschließt, dass der Isolier-Film (9) auf dem Abschnitt (3) mit einer geschichteten Struktur aus Filmen mit niedriger Dielektrizitätskonstante und in der Nut (23) ausgebildet wird und der Isolier-Film (9) so strukturiert wird, dass sich Seitenflächen des Isolier-Films (9) von den Seitenflächen des Abschnitts (3) mit einer geschichteten Struktur aus Filmen mit niedriger Dielektrizitätskonstante und Leiterbahnen aus innen befinden.

19. Verfahren zum Herstellen einer Halbleiter-Vorrichtung nach Anspruch 10, wobei das Fertigen eines Halbleiter-Wafers (21), an dessen einer Fläche ein Abschnitt (3) mit einer geschichteten Struktur aus Filmen mit niedriger Dielektrizitätskonstante und Leiterbahnen ausgebildet ist, einschließt, dass der Isolier-Film (14) auf dem Abschnitt (3) mit einer geschichteten Struktur aus Filmen mit niedriger Dielektrizitätskonstante und Leiterbahnen strukturiert wird, um zu verhindern, dass sich der aus einem organischen Kunststoff bestehende Isolier-Film oberhalb der Trennspur (22) erstreckt.

20. Verfahren zum Herstellen einer Halbleiter-Vorrichtung nach Anspruch 10, das des Weiteren umfasst:
Ausbilden eines Kontaktinsel-Abschnitts für eine Elektrode auf dem Isolier-Film (9), so dass er mit einem Kontaktinsel-Abschnitt einer obersten Leiterbahn (5) des Abschnitts (3) mit einer geschichteten Struktur aus Filmen mit niedriger Dielektrizitätskonstante und Leiterbahnen verbunden ist; und
Ausbilden einer Bump-Elektrode für externen Anschluss an dem Kontaktinsel-Abschnitt für die Elektrode,
wobei das Ausbilden eines Films (9, 14) aus organischem Kunststoff einschließt, dass ein Isolier-Film (9), der aus einem organischen Kunststoff besteht, auf dem Abschnitt (3) mit einer geschichteten Struktur aus Filmen mit niedriger Dielektrizitätskonstante und Leiterbahnen ausgebildet wird, und ein Abdicht-Film (14) ausgebildet wird, der aus einem organischen Kunststoff besteht und eine obere Fläche des Isolier-Films (9) um die Bump-Elektrode (13) für externen Anschluss herum, Seitenflächen des Isolier-Films (9) sowie die Seitenflächen des Abschnitts (3) mit einer geschichteten Struktur aus Filmen mit niedriger Dielektrizitätskonstante und Leiterbahnen abdeckt.

## Revendications

1. Dispositif semiconducteur comprenant :
un substrat semiconducteur (1) ;
une partie de structure stratifiée de ligne de câblage de film diélectrique faible (3) prévue dans des régions à l'exclusion des parties périphériques d'une surface du substrat semiconducteur (1), et la partie de structure stratifiée de ligne de câblage de film diélectrique faible (3) constituant une structure stratifiée incluant une pluralité de films diélectriques faibles (4) et une pluralité de lignes de câblage (5), chacun des films diélectriques faibles ayant une constante diélectrique relative de 3,0 ou inférieure et une température de transition vitreuse de 400 °C ou supérieure ;
un film isolant recouvrant la surface supérieure de la partie de structure stratifiée de ligne de câblage de film diélectrique faible (3) ;
une partie de plot de connexion pour une électrode, ladite partie de plot de connexion pour une électrode étant agencée sur ledit film isolant (9) prévu sur la partie de structure stratifiée de ligne de câblage de film diélectrique faible (3), de telle sorte que ladite partie de plot de connexion pour une électrode soit reliée à une partie de plot de connexion (5a) d'une ligne de câblage supérieure (5) de la partie de structure stratifiée de ligne de câblage de film diélectrique faible (3) ;
une électrode à bosse (13) pour connexion externe, prévue sur la partie de plot de connexion pour l'électrode ; et
un film de scellement (14) fait d'une résine organique et prévu au moins sur une partie du film isolant (9) de façon à entourer l'électrode à bosse (13) pour la connexion externe,
**caractérisé en ce que** les surfaces latérales de la partie de structure stratifiée de ligne de câblage de film diélectrique faible (3) sont également recouvertes par le film isolant (9).

2. Dispositif semiconducteur selon la revendication 1, comprenant en outre un film de passivation (7) fait d'une matière inorganique entre le film isolant (9) et la partie de structure stratifiée de ligne de câblage de film diélectrique faible (3).

3. Dispositif semiconducteur selon la revendication 2, dans lequel des surfaces latérales correspondantes du film isolant (9), du film de passivation (7) et de la partie de structure stratifiée de ligne de câblage de film diélectrique faible (3) forment un plan et les surfaces latérales du film isolant (9), du film de passivation (7) et de la partie de structure stratifiée de ligne de câblage de film diélectrique faible (3) sont recouvertes par le film de scellement (14).

4. Dispositif semiconducteur selon la revendication 2, dans lequel les surfaces latérales correspondantes du film de passivation (7) et de la partie de structure stratifiée de ligne de câblage de film diélectrique faible (3) forment un plan et les surfaces latérales du film de passivation (7) et de la partie de structure stratifiée de ligne de câblage de film diélectrique faible (3) sont recouvertes par le film isolant (9).

5. Dispositif semiconducteur selon la revendication 2, dans lequel les surfaces latérales du film isolant (9) sont situées vers l'intérieur par rapport aux surfaces latérales de la partie de structure stratifiée de ligne de câblage de film diélectrique faible (3).

6. Dispositif semiconducteur selon la revendication 5, dans lequel les surfaces latérales du film de passivation (7) sont situées vers l'intérieur par rapport aux surfaces latérales correspondantes du film isolant (9).

7. Dispositif semiconducteur selon la revendication 5, dans lequel les surfaces latérales correspondantes du film isolant (9) et du film de passivation (7) forment un plan.

8. Dispositif semiconducteur selon la revendication 1, dans lequel la partie de structure stratifiée de ligne de câblage de film diélectrique faible (3) comporte un film de passivation inférieur (16) formé entre la ligne de câblage supérieure (5) et le film diélectrique faible supérieur (4).

9. Dispositif semiconducteur selon l'une quelconque des revendications 1 à 8, dans lequel le film diélectrique faible (14) comporte un matériau parmi un matériau à base de polysiloxane comportant une liaison Si-O et une liaison Si-H, un matériau à base de polysiloxane comportant une liaison Si-O et une liaison Si-CH3, un oxyde de silicium dopé au carbone et un matériau à faible k à base de polymère organique ou un type poreux d'un oxyde parmi un oxyde de silicium dopé au fluor, un oxyde de silicium dopé au bore et un oxyde de silicium.

10. Procédé de fabrication d'un dispositif semiconducteur, comprenant :
la préparation d'une plaquette de semiconducteur (21) sur une surface de laquelle est formée une partie de structure stratifiée de ligne de câblage de film diélectrique faible (3), la partie de structure stratifiée de ligne de câblage de film diélectrique faible (3) incluant des films diélectriques faibles (4) et des lignes de câblage (5), les films diélectriques faibles ayant une constante diélectrique relative de 3,0 ou inférieure et une température de transition vitreuse de 400 °C ou supérieure ; et
le retrait de parties de la partie de structure stratifiée de ligne de câblage de film diélectrique faible (3) dans des régions situées au-dessus d'allées de découpage (22) et des régions sur les côtés opposés des allées de découpage en appliquant des faisceaux laser, et la formation d'une gorge (23) exposant les surfaces latérales de la partie de structure stratifiée de ligne de câblage de film diélectrique faible (3) ;
la formation d'un film isolant recouvrant la surface supérieure et les surfaces latérales de la partie de structure stratifiée de ligne de câblage de film diélectrique faible (3) ; et la formation d'une électrode à bosse (13) pour connexion externe du plot relié à une partie de plot de connexion (5a) d'une ligne de câblage supérieure (5) de la partie de structure stratifiée de ligne de câblage de film diélectrique faible (3) ;
la formation d'un film de scellement (14) fait d'une résine organique sur le film isolant (9) de façon à entourer l'électrode à bosse (13) pour la connexion externe, et
le découpage du film isolant (9), du film de scellement (14) formé sur le film isolant (9) et de la plaquette de semiconducteur (21) le long des allées de découpage (22), de façon à obtenir une pluralité de dispositifs semiconducteurs.

11. Procédé de fabrication d'un dispositif semiconducteur selon la revendication 10, dans lequel la formation d'une gorge (23) comporte la formation d'un film de protection soluble dans l'eau (17) entièrement sur le film de résine organique (9) avant de former la gorge (23), et le retrait du film de protection soluble dans l'eau (17) après avoir formé la gorge (23).

12. Procédé de fabrication d'un dispositif semiconducteur selon la revendication 10, dans lequel la formation du film de résine organique (9, 14) comporte la formation d'un film isolant (9) fait d'une résine organique recouvrant la partie supérieure de la partie de structure stratifiée de ligne de câblage de film diélectrique faible (3).

13. Procédé de fabrication d'un dispositif semiconducteur selon la revendication 12, comprenant en outre
la formation d'une partie de plot de connexion pour une électrode sur le film isolant (9) de manière à être connectée à une partie de plot de connexion d'une ligne de câblage supérieure (5) de la partie de structure stratifiée de ligne de câblage de film diélectrique faible (3) ; et
la formation d'une électrode à bosse (13) pour connexion externe sur la partie de plot de connexion pour l'électrode.

14. Procédé de fabrication d'un dispositif semiconducteur selon la revendication 10, dans lequel la préparation d'une plaquette de semiconducteur (21), sur une surface de laquelle est formée une partie de structure stratifiée de ligne de câblage de film diélectrique faible (3) comporte la préparation de la partie de structure stratifiée de ligne de câblage de film diélectrique faible (3) sur laquelle est formé un film isolant (9) fait de résine organique, et la formation d'une gorge comporte le retrait de parties du film isolant (9) et de la partie de structure stratifiée de ligne de câblage de film diélectrique faible (3) dans les régions situées au-dessus des allées de découpage (22) et les régions situées sur les côtés opposés des allées de découpage en appliquant des faisceaux laser et la formation des surfaces latérales d'exposition de la gorge (23) du film isolant (9) et de la partie de structure stratifiée de ligne de câblage de film diélectrique faible (3).

15. Procédé de fabrication d'un dispositif semiconducteur selon la revendication 10, dans lequel la préparation d'une plaquette de semiconducteur (21) sur une surface de laquelle est formée une partie de structure stratifiée de ligne de câblage de film diélectrique faible (3) comporte la préparation de la partie de structure stratifiée de ligne de câblage de film diélectrique faible (3) sur laquelle est formé un film de passivation (7), et la formation d'une gorge (23) comporte le retrait de parties du film de passivation (7) et de la partie de structure stratifiée de ligne de câblage de film diélectrique faible (3) dans les régions situées au-dessus des allées de découpage (22) et les régions situées sur les côtés opposés de l'allée de découpage, et la formation des surfaces latérales d'exposition de la gorge (23) du film de passivation (7) et des surfaces latérales de la partie de structure stratifiée de ligne de câblage de film diélectrique faible (3).

16. Procédé de fabrication d'un dispositif semiconducteur selon la revendication 15, dans lequel la formation d'un film de résine organique (9, 14) comporte la formation d'un film isolant (9, 14) fait d'une résine organique recouvrant la surface supérieure du film de passivation (7) et les surfaces latérales du film de passivation (7) et les surfaces latérales de la partie de structure stratifiée de ligne de câblage de film diélectrique faible (3) exposées à travers la gorge (23).

17. Procédé de fabrication d'un dispositif semiconducteur selon la revendication 16, dans lequel la formation d'un film isolant (9, 14) comporte la formation d'un motif du film isolant (9, 14) pour empêcher le film isolant (9, 14) de s'étendre au-dessus de l'allée de découpage (22).

18. Procédé de fabrication d'un dispositif semiconducteur selon la revendication 17, dans lequel la formation d'un film isolant (9, 14) comporte la formation du film isolant (9) sur la partie de structure stratifiée de ligne de câblage de film diélectrique faible (3) et dans la gorge (3) et la formation d'un motif du film isolant (9) de telle sorte que les surfaces latérales du film isolant (9) soient situées vers l'intérieur par rapport aux surfaces latérales de la partie de structure stratifiée de ligne de câblage de film diélectrique faible (3).

19. Procédé de fabrication d'un dispositif semiconducteur selon la revendication 10, dans lequel la préparation d'une plaquette de semiconducteur (21) sur une surface de laquelle est formée une partie de structure stratifiée de ligne de câblage de film diélectrique faible (3) comporte la formation d'un motif du film isolant (14) sur la partie de structure stratifiée de ligne de câblage de film diélectrique faible (3) pour empêcher le film isolant (14) fait d'une résine organique de s'étendre au-dessus de l'année de découpage (22).

20. Procédé de fabrication d'un dispositif semiconducteur selon la revendication 10, comprenant en outre :
la formation d'une partie de plot de connexion pour une électrode sur le film isolant (9) de façon à être connectée à une partie de plot de connexion d'une ligne de câblage supérieure (5) de la partie de structure stratifiée de ligne de câblage de film diélectrique faible (3) ; et
la formation d'une électrode à bosse (13) pour connexion externe sur la partie de plot de connexion pour l'électrode,
dans lequel la formation d'un film de résine organique (9, 14) comporte la formation d'un film isolant (9) fait d'une résine organique sur la partie de structure stratifiée de ligne de câblage de film diélectrique faible (3) et la formation d'un film de scellement (14) fait d'une résine organique recouvrant la surface supérieure du film isolant (9) autour de l'électrode à bosse (13) pour connexion externe, les surfaces latérales du film isolant (9) et les surfaces latérales de la partie de structure stratifiée de ligne de câblage de film diélectrique faible (3).
